# EUROPÄISCHE PATENTSCHRIFT

(11) **EP 3 129 524 B1**
(45) Veröffentlichungstag und Bekanntmachung des Hinweises auf die Patenterteilung: **06.05.2020**
(21) Anmeldenummer: 15710529.7
(22) Anmeldetag: 19.03.2015
(51) Int. Cl.: C23C 16/46, C01B 32/16, C01B 32/186, C23C 16/26, C23C 16/458, C23C 16/455, C01B 32/05, C01B 32/182

(54) **VORRICHTUNG ZUM ABSCHEIDEN VON NANOTUBES**
DEVICE FOR DEPOSITING NANOTUBES
DISPOSITIF DE DÉPÔT DE NANOTUBES

(30) Priorität: 24.03.2014 DE 102014104011
(43) Veröffentlichungstag der Anmeldung: 15.02.2017
(73) Patentinhaber: Aixtron SE, 52134 Herzogenrath (DE)
(72) Erfinder: JOUVRAY, Alexandre, Hilton Huntington PE28 9QB (GB); RIPPINGTON, David Eric, Stetchworth Newmarket Suffolk CB8 9TZ (GB); TEO, Kenneth B. K., Cambridge Cambridgeshire CB23 5BH (GB); RUPESINGHE, Nalin L., Cambridge Cambridgeshire CB4 3NB (GB)
(74) Vertreter: Grundmann, Dirk
(86) Internationale Anmeldenummer: PCT/EP2015/055801
(87) Internationale Veröffentlichungsnummer: WO 2015/144558

(56) Entgegenhaltungen:
- WO-A1-2013/069593
- WO-A1-2014/038803
- CN-A- 1 924 659
- JP-A- 2013 026 358
- KR-A- 20130 098 664
- US-A1- 2012 003 389

## Beschreibung

Die Erfindung betrifft eine Vorrichtung zum Abscheiden von kohlenstoffhaltigen Strukturen beispielsweise Schichten in Form von Nanoröhrchen oder Graphene auf einem Substrat, welches von einem in einem Prozesskammergehäuse angeordneten Substratträger getragen wird, wobei durch Gasaustrittsöffnungen eines im Prozesskammergehäuse angeordneten Gaseinlassorgans ein Prozessgas in Richtung auf das mindestens eine Substrat einspeisbar ist.

Eine Vorrichtung zum Beschichten von Substraten zeigen die DE 195 22 574 A1, US 2010/0319766 A1 und US 2013/0084235 A1. Die Substrate liegen teilweise auf Substratträgern; teilweise befinden sich die Substrate aber auch frei zwischen zwei sich gegenüberliegenden Gaseinlassorganen. Die US 2013/0089666 A1 beschreibt ein zwei Breitseitenflächen aufweisendes Kupfersubstrat.

Die Erfindung betrifft eine Vorrichtung zum Abscheiden von Nano-Röhrchen aus Kohlenstoff. Hierzu werden gasförmige Ausgangsstoffe in eine Prozesskammer gebracht. Dies erfolgt mittels eines Gaseinlassorgans. Innerhalb der Prozesskammer befindet sich ein Substrat, das auf einem Substratträger angeordnet ist. Es wird ein kohlenstoffhaltiges Prozessgas, beispielsweise CH₄, C₂H₄, C₂H₂ oder C₆H₆ in die Prozesskammer eingebracht. Vorrichtungen zum Beschichten flexibler Substrate beschreiben u.a. die GB 2 458 776 A oder die JP 2005-133165 A.

Die US 2012/0000425 A1 beschreibt eine Vorrichtung zum thermischen Behandeln von Substraten, bei der mehrere Substratträger horizontal übereinanderliegend in einer Prozesskammer angeordnet sind.

Die US 2008/0152803 A1 beschreibt eine Vorrichtung zum thermischen Behandeln von Substraten, wobei die Substrate strahlenförmig in einer Prozesskammer angeordnet sind.

Der Erfindung liegt die Aufgabe zugrunde, eine gattungsgemäße Vorrichtung gebrauchsvorteilhaft weiterzubilden.

Gelöst wird die Aufgabe durch die in den Ansprüchen angegebene Erfindung.

Zunächst und im Wesentlichen wird vorgeschlagen, dass das Prozesskammergehäuse Wände mit Hohlräumen aufweist, durch die das Gasvolumen des Gaseinlassorganes mit Prozessgasen gespeist wird. Die Wände des Prozesskammergehäuses sind demzufolge mit Füllungen versehen, in die von außen her das Prozessgas eingespeist werden kann, so dass es durch Gaseinspeiseöffnungen insbesondere vom Rand her in das Gasvolumen des Gaseinlassorganes eingespeist werden kann. Innerhalb des Prozesskammergehäuses ist bevorzugt eine Vielzahl von plattenförmigen Elementen angeordnet. Die plattenförmigen Elemente besitzen an ihren voneinander wegweisenden Rändern Randabschnitte, die in Halteaussparungen eingeschoben sind, die von zwei parallel zueinander verlaufenden Wänden des Prozesskammergehäuses ausgebildet sind. Die Halteaussparungen sind vorzugsweise von Nuten mit parallel zueinander verlaufenden Nutwänden ausgebildet. Die Öffnungen der Nuten der beiden Wände weisen aufeinander zu. In jeweils ein Nutpaar kann eine rechteckige Platte eingeschoben werden. Das Prozesskammergehäuse besitzt vorzugsweise einen klappsymmetrischen Aufbau. Die Symmetrieebene ist eine Mittelebene, in der sich ein Substratträger befinden kann. Der Substratträger kann auf seinen voneinander wegweisenden Breitseiten jeweils Substrate tragen, die gleichzeitig beschichtet werden können. Hierzu besitzt das Prozesskammergehäuse auf beiden Seiten des sich in Vertikalrichtung erstreckenden Substratträgers ein Gasauslassorgan. Das jeweilige Gasauslassorgan wird von einem plattenförmigen Element ausgebildet, welches eine Vielzahl von Gasaustrittsöffnungen besitzt. Es handelt sich dabei um eine Gaseinlassplatte, durch die das Prozessgas in die Prozesskammer einströmen kann, in deren Mitte sich der Substratträger befindet. Rückwärtig der Gaseinlassplatte befindet sich eine Rückwand, mit der ein Gasvolumen des Gaseinlassorganes in Richtung weg von der Prozesskammer verschlossen ist. Gaseinlassplatte und Rückwand bilden jeweils Randabschnitte, die in Halteaussparungen eingeschoben sind. Eine Gaseinspeisung des Prozessgases erfolgt erfindungsgemäß von der Prozesskammergehäusewand her. Das Gasvolumen des Gaseinlassorganes befindet sich bevorzugt in einem Zwischenraum zwischen einer Gaseinlassplatte und einer Rückwand. Die Prozesskammergehäusewand besitzt eine Vielzahl von in den Zwischenraum zwischen Gaseinlassplatte und Rückwand mündende Gaseinspeiseöffnungen. Die Prozesskammergehäusewand besitzt eine Höhlung, in die von außen Prozessgas eingespeist werden kann. Die Höhlung verteilt das Prozessgas an die einzelnen Einspeiseöffnungen, die in das Gasvolumen des Gaseinlassorgans münden. Rückwärtig der Rückwand befindet sich eine Quarzplatte. Rückwärtig der Quarzplatte befindet sich eine Widerstandsheizung, die infrarote Strahlung erzeugt. Die Quarzplatte und die beiden das Gaseinlassorgan bildenden Platten sind transparent für infrarote Strahlung und bestehen aus Quarz. Es kann ferner vorgesehen sein, dass eine Rückwand und ein Reflektor ebenfalls Randabschnitte besitzen, die in Halteaussparungen eingeschoben sind. Ein Austausch der plattenförmigen Elemente, die in den Halteaussparungen eingeschoben sind, also der Gaseinlassplatte, der Rückwand, der Quarzplatte, des Reflektors oder der Rückwand ist in einfacher Weise ermöglicht. Es ist lediglich erforderlich, eine Decke des Prozesskammergehäuses zu entfernen. Die plattenförmigen Elemente können dann durch die sich in Vertikalrichtung erstreckenden Halteaussparungen aus dem Prozesskammergehäuse herausgezogen werden. In umgekehrter Weise erfolgt die Zuordnung der plattenförmigen Elemente zu dem Prozesskammergehäuse. Das Prozesskammergehäuse ist bevorzugt innerhalb eines Reaktorgehäuses angeordnet. Das Reaktorgehäuse kann einen Deckel aufweisen, so dass die Decke des Prozesskammergehäuses zugänglich ist. Bei geschlossenem Deckel ist das Reaktorgehäuse gasdicht, so dass es evakuiert werden kann.

Die Erfindung betrifft darüber hinaus eine Vorrichtung zum Abscheiden von insbesondere kohlenstoffhaltigen Strukturen beziehungsweise Schichten von Nanoröhrchen oder Graphene auf einem Substrat, wobei das Prozesskammergehäuse zwei sich gegenüberliegende und zum Substratträger senkrechte Wände mit Halteaussparungen aufweist, in denen zwei voneinander wegweisende Randabschnitte eines plattenförmigen Bauteiles steckt. Das plattenförmige Bauteil kann die Gaseinlassplatte, eine Rückwand des Gaseinlassorganes, eine Abschirmplatte, ein Reflektor oder eine Rückwand des Prozesskammergehäuses sein. Erfindungsgemäß ist zumindest eines dieser plattenförmigen Bauteile durch seine Verlagerung in seine Erstreckungsebene aus dem Prozesskammergehäuse entfernbar.

Ein Ausführungsbeispiel der Erfindung wird nachfolgend anhand beigefügter Zeichnungen erläutert. Es zeigen:
- Fig. 1: eine Explosionsdarstellung eines Substratträgers,
- Fig. 2: die Breitseitenansicht eines Substratträgers,
- Fig. 3: die Schmalseitenansicht eines Substratträgers,
- Fig. 4: den Schnitt gemäß der Linie IV-IV in Figur 2, wobei auf jeder der beiden Breitseitenflächen des Substratträgers je ein Substrat 6 angeordnet ist,
- Fig. 5: eine Darstellung gemäß Figur 4, wobei der Substratträger 1 ein flexibles Substrat 6 trägt, das sich über die Randkante 11 erstreckt,

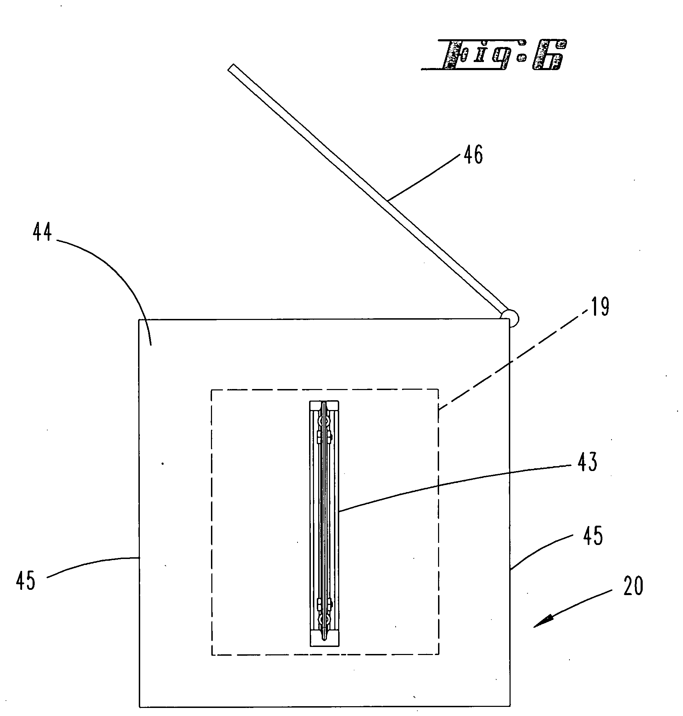

- Fig. 6: eine Seitenansicht auf ein Reaktorgehäuse 20 mit geöffnetem Deckel 46 und angedeutetem, darin angeordnetem Prozesskammergehäuse 19,

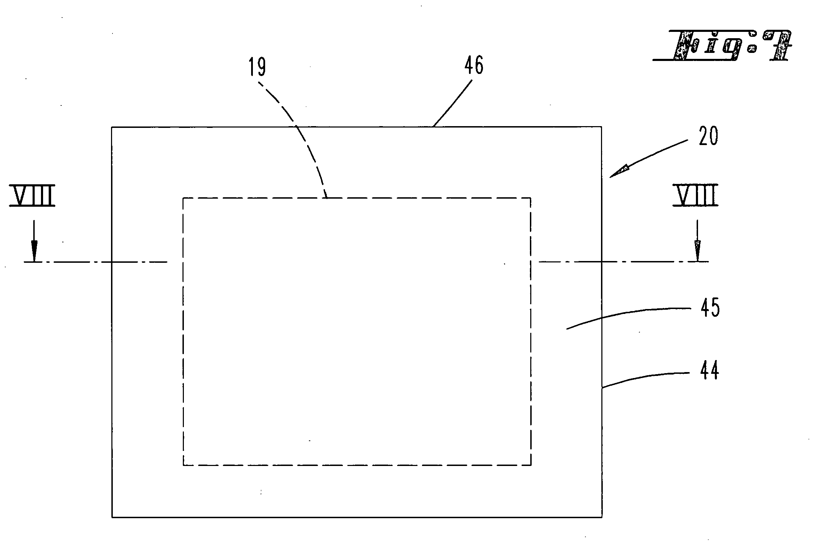

- Fig. 7: das Reaktorgehäuse 20 in der Frontansicht mit geschlossenem Deckel und angedeutetem, darin angeordnetem Prozesskammergehäuse 19,

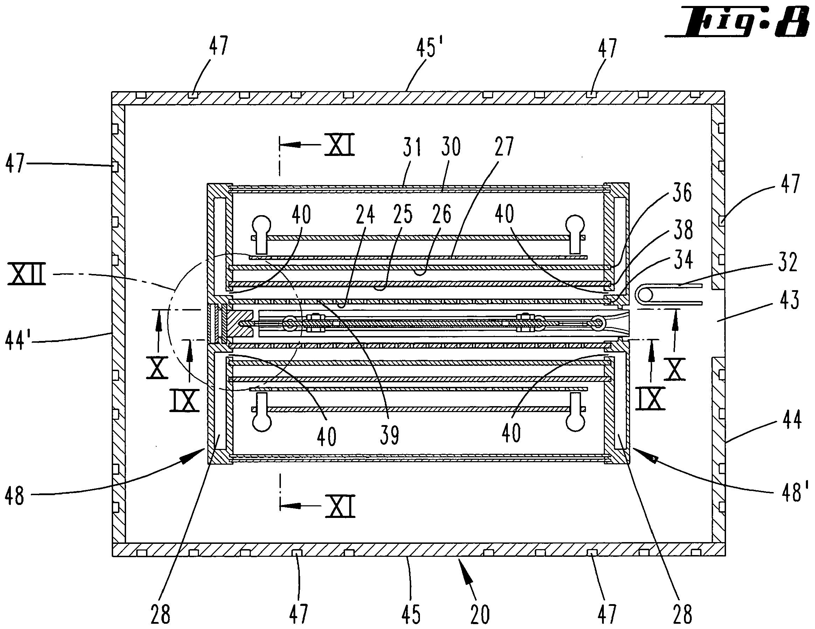

- Fig. 8: einen Schnitt gemäß der Linie VIII-VIII in Figur 7,
- Fig. 9: einen Schnitt gemäß der Linie IX-IX in Figur 8 mit Blick auf den im Prozesskammergehäuse 19 angeordnetem Substratträger 10,

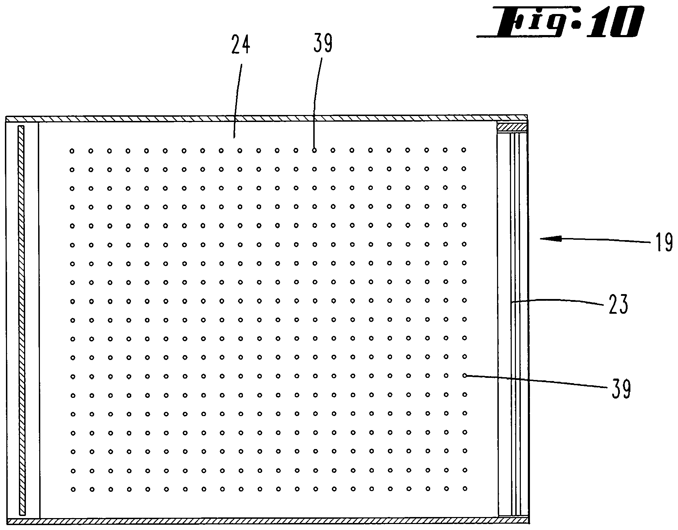

- Fig. 10: einen Schnitt gemäß der Linie X-X in Figur 8 mit Blick auf die Gasauslassplatte 24,

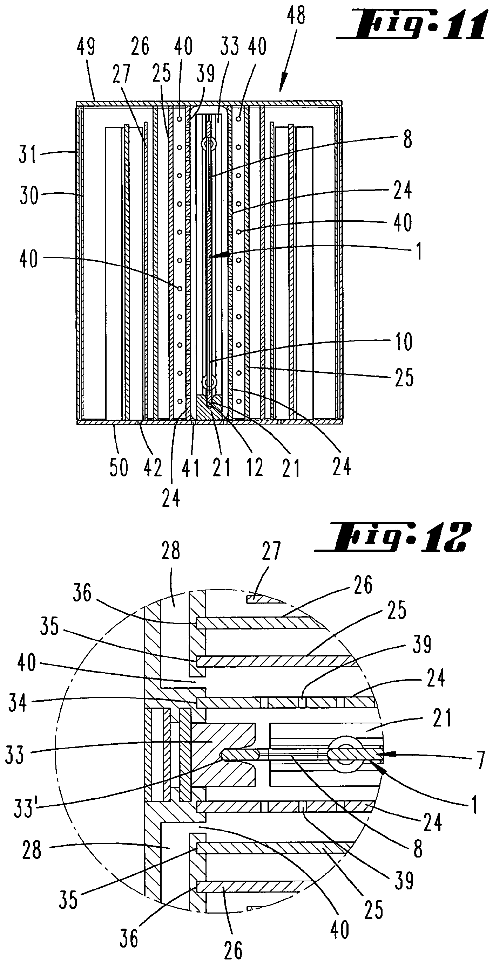

- Fig. 11: einen Schnitt gemäß der Linie XI-XI in Figur 8 mit Blick auf die prozesskammergehäuseinnenseitige Seite einer Wandung 48 des Prozesskammergehäuses 19,
- Fig. 12: vergrößert den Ausschnitt XII in Figur 8.

Das in den Zeichnungen dargestellte Reaktorgehäuse 20 besitzt eine quaderförmige Gestalt mit vier Seitenwänden 44, 44'; 45, 45'. Die obere Gehäusewand bildet einen aufschwenkbaren Deckel 46. Im Betrieb des Reaktors ist der Deckel 46 geschlossen. Er kann allerdings zu Wartungszwecken geöffnet werden.

Die Seitenwände 44, 44'; 45, 45' besitzen Kanäle 47, durch die eine Kühlflüssigkeit hindurchströmen kann, um die Wände 44, 44'; 45, 45' zu spülen.

Eine der Seitenwände 44 besitzt eine sich in Vertikalrichtung erstreckende Öffnung 43. Die Öffnung 43 kann mit einem nicht dargestellten Schieber gasdicht verschlossen werden. Es handelt sich um eine Be- und Entladeöffnung.

Innerhalb des Reaktorgehäuses 20 befindet sich ein Prozesskammergehäuse 19, welches ebenfalls eine sich in Vertikalrichtung erstreckende Be- und Entladeöffnung 23 aufweist. Das Prozesskammergehäuse 19 besitzt in seinem Inneren ein unteres Führungselement 21 und ein oberes Führungselement 22. Beide Führungselemente 21, 22 haben eine Leistenform und besitzen aufeinander zu weisende Nuten 21', 22'. Zwei Gaseinlassorgane 24, 25 begrenzen Vertikalseiten einer Prozesskammer. Ein Substratträger 1 kann durch die vertikalen Beladeöffnungen 23, 43 in die Prozesskammer eingeschoben werden. Hierbei greifen Führungsabschnitte 12 des Substratträgers 1 in Nuten 21', 22' der Führungselemente 21, 22 ein. Im eingesetzten Zustand befindet sich der Substratträger 1 mittig zwischen den beiden Gaseinlassorganen 24. Alle sechs Wände des quaderförmigen Reaktorgehäuses 20 können Temperierkanäle 47 aufweisen, durch die eine Temperierflüssigkeit strömen kann, um die Reaktorwände entweder zu kühlen oder aufzuheizen.

Der Substratträger 1 ist ein Flachkörper und besitzt einen im Wesentlichen rechteckigen Grundriss. Er besitzt zwei voneinander wegweisende Breitseitenflächen 2, 3, die jeweils eine Substrat-Aufnahmezone 4, 5 ausbilden. Die voneinander wegweisenden Substrat-Aufnahmezonen 4, 5 haben einen im Wesentlichen rechteckigen Querschnitt.

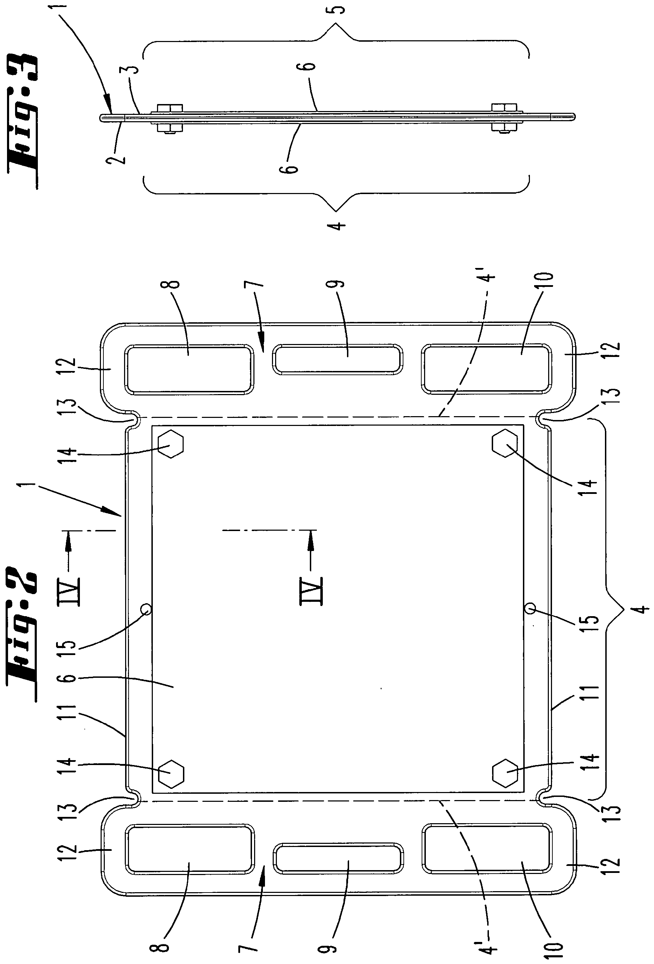

Die Figur 2 zeigt eine Breitseitenflächen 2 mit der Substrat-Aufnahmezone 4. Die gegenüberliegende Breitseitenflächen 3 ist mit ihrer Substrat-Aufnahmezone 5 identisch ausgebildet.

Der Flachkörper, aus dem der Substratträger 1 besteht, hat eine Materialstärke, die geringer ist als 10 mm. Die Randkantenlänge des Substratträgers 1 beträgt mindestens 100 mm.

Die Substrat-Aufnahmezone 4, die zur Substrat-Aufnahmezone 5 gleichgestaltet ist, besitzt zwei erste Ränder 4'. Bei den ersten Rändern 4' handelt es sich um gedachte Linien. Die Substrat-Aufnahmezone 4 besitzt darüber hinaus zweite Ränder, die von Randkanten 11 des Substratträgers 1 ausgebildet sind. Die Randkanten 11 sind verrundet.

In Eckbereichen der Substrat-Aufnahmezonen 4, 5 befinden sich Fixierelemente 14. Die Fixierelemente 14 sind im Ausführungsbeispiel als Schrauben 14 mit Muttern 14' dargestellt. Die Fixierelemente 14,14' können aber auch Klemmelemente sein. Mit diesen Fixierelementen 14,14' wird ein im Wesentliches rechteckiges Substrat 6 auf einer der beiden Substrat-Aufnahmezonen 4, 5 befestigt. Jeweils ein Substrat 6 befindet sich auf einer der beiden Breitseitenflächen 2, 3, so dass die beiden voneinander wegweisenden Substrat-Aufnahmezonen 4, 5 jeweils ein im Wesentlichen rechteckiges Substrat 6 tragen, wobei die Substrate 6 mit den Fixierelementen 14,14' am Substratträger 1 befestigt sind. Bei den Substraten kann es sich um Kupfer-, Aluminium- oder um Nickelsubstrate handeln, die mit aus Kohlenstoff bestehenden Nanoröhrchen beschichtet werden, die quer zur Erstreckungsebene auf der Substratoberfläche aufwachsen.

Die Randkanten 11 gehen unter Ausbildung einer Einbuchtung 13 in Vorsprünge 12 über. Es handelt sich dabei um die oben erwähnten Führungsvorsprünge. Diese werden von den beiden Endabschnitten von Randabschnitten 7 des Substratträgers 1 ausgebildet. Die Randabschnitte 7 grenzen unmittelbar an die Ränder 4' an. An jeweils einem der beiden voneinander wegweisenden Ränder 4' grenzt ein Randabschnitt 7 an, der jeweils einen Handhabungsabschnitt ausbildet. Die Vorsprünge 12 erstrecken sich in der Erstreckungsebene des Substratträgers 1 und bilden Randabschnitte aus, die von der Randkante 11 beabstandet sind.

Die beiden gleich gestalteten Handhabungsabschnitte 7 besitzen nicht nur die die jeweilige Randkante 11 der Substrat-Aufnahmezone 4, 5 überragenden Vorsprünge 12, sondern auch fensterartige Öffnungen 8, 9, 10. Es handelt sich dabei um drei Rechtecköffnungen, durch die Gas hindurchströmen kann, die aber auch zur manuellen Handhabung verwendet werden können. Hierzu werden die Öffnungen 8, 9, 10 als Grifföffnungen verwendet. Die mittlere rechteckige Öffnung kann von einem Greifer eines Handhabungsarmes gegriffen werden.

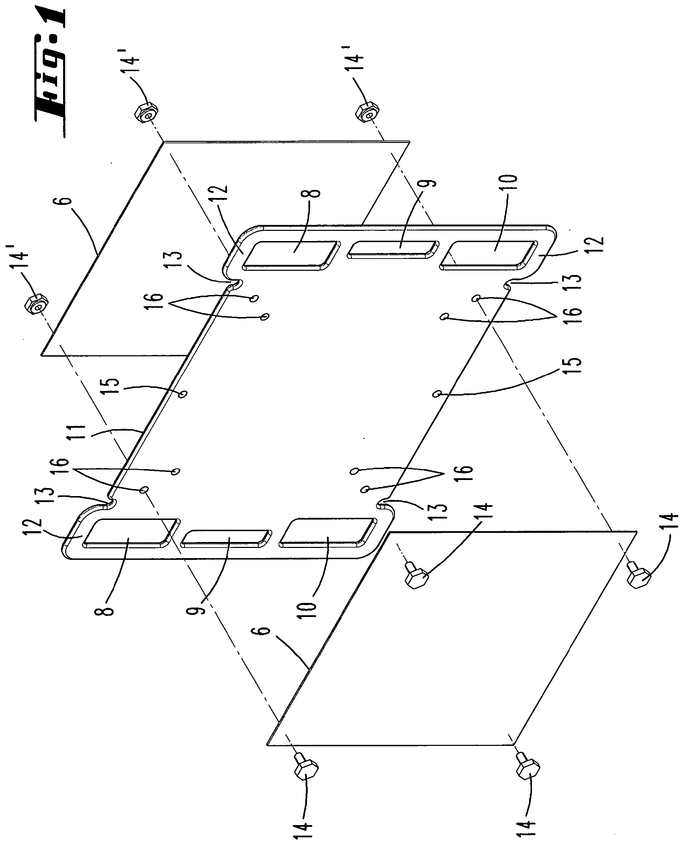

Wie die Figur 1 zeigt, besitzt der Substratträger 1 diverse Bohrungen 15,16. Die Bohrungen 16 dienen der Fixierung der Fixierelemente 14 am Substratträger 1. Die Bohrung 15 kann ebenfalls als Befestigungsbohrung für ein Fixierelement verwendet werden. Die Bohrung 15 kann aber auch ein Anschlagelement aufweisen.

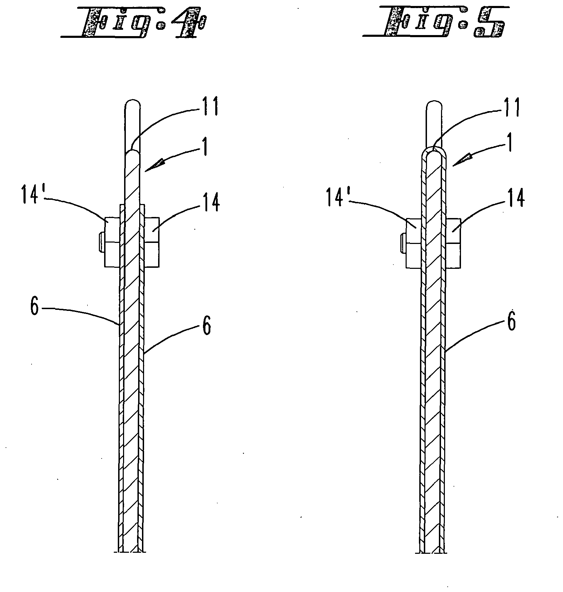

Die Figur 4 zeigt eine erste Verwendungsart des Substratträgers 1, bei der der Substratträger 1 auf seinen voneinander wegweisenden Breitseitenflächen 2, 3 jeweils ein Substrat 6 trägt.

Die Figur 5 zeigt eine zweite Verwendungsart des Substratträgers 1. Hierbei ist das vom Substratträger 1 getragene Substrat 6 flexibel. Es besitzt zwei Endabschnitte, die jeweils einer der beiden Substrat-Aufnahmezonen 4, 5 zugeordnet sind und dort befestigt sind. Ein mittlerer Abschnitt des Substrates 6 liegt an der gerundeten Randkante 11 an. Das Substrat 6 ist somit U-förmig um die Randkante 11 gefaltet.

Bei dem Substrat kann es sich um eine dünne Kupfer-, Nickel- oder Aluminiumfolie handeln. Mit den Gaseinlassorganen 24 wird ein Prozessgas (H₂, NH₃, AR, N₂, CH₄, C₂H₄, C₂H₂ oder C₆H₆) in die Prozesskammer eingeleitet. Durch eine chemische, insbesondere katalytische Reaktion zerlegen sich die Kohlenwasserstoffe in Kohlenstoff. Es kann sich dabei um eine pyrolytische Oberflächenreaktion handeln. Auf dem Substrat scheidet sich Graphene ab oder es scheiden sich dort Nano-Tubes ab.

Der Innenraum des Reaktorgehäuses 20 kann evakuiert werden. Hierzu dient eine nicht dargestellte Vakuumpumpe.

Das Prozesskammergehäuse 19 besitzt sechs Wände, die zu zugeordneten Wänden 44,44'; 45, 45' beziehungsweise 48, 31, 49, 50 des Reaktorgehäuses 20 parallel verlaufen. Die Wände des Prozesskammergehäuses 19 sind von den Wänden des Reaktorgehäuses 20 beabstandet.

Zumindest eine Wand 48 des Prozesskammergehäuses 19 bildet einen oder mehrere Hohlräume 28 aus. Dieser mindestens ein Hohlraum 28 ist Bestandteil einer Gaseinspeiseeinrichtung. Der Hohlraum 28 kann von außen her mit einem Prozessgas gespeist werden, das, wie weiter unten noch erläutert wird, über Öffnungen 40 in das Innere des Prozesskammergehäuses 19 eintreten kann. Es sind zwei sich gegenüberliegende Gehäusewände 48, 48' vorgesehen, die mehrteilig ausgebildet sind. Die Gehäusewandung 48' bildet die oben erwähnte Beladeöffnung 23 aus. Beide Gehäusewände 48, 48' besitzen auf ihrer zum Inneren des Prozesskammergehäuses 19 gewandten Seite eine Vielzahl von parallel zueinander und in Vertikalrichtung verlaufenden Halteaussparungen 34 bis 38. Die Halteaussparungen 34 bis 38 werden jeweils von Vertikalnuten gebildet. In den Halteaussparungen 34 bis 38 befinden sich die Ränder von plattenförmigen Elementen 24, 25, 26, 30, 31 des Prozesskammergehäuses 19. Bezogen auf eine Mittelebene hat das Prozesskammergehäuse 19 eine klappsymmetrische Gestalt. In dieser Mittelebene befindet sich der Substratträger 1 beziehungsweise befinden sich die Halteelemente 21, 22 und 33, die jeweils Nuten 21', 22' und 33' aufweisen zur Halterung des Substratträgers 1.

Auf mindestens einer der Breitseite des Substratträgers 1 befindet sich ein das Gaseinlassorgan in Form eines Showerheads. Beim Ausführungsbeispiel befindet sich auf jeder beiden Breitseiten des Substratträgers ein Gaseinlassorgan jeweils in Form eines Showerheads.

Auf jeder der beiden Breitseiten des Substratträgers 1 befindet sich ein Gaseinlassorgan jeweils in Form eines Showerheads. Der jeweilige Showerhead wird von einer aus Quarz gefertigten Gaseinlassplatte 24 ausgebildet, die mit zwei voneinander weg weisenden Rändern jeweils in eine Halteaussparung 34 eingeschoben ist. Die Gaseinlassplatte 24 besitzt eine Vielzahl von gleichmäßig über die Fläche der Gaseinlassplatte 24 verteilt angeordnete Gasaustrittsöffnungen 39, zum Austritt eines von einem Trägergas transportierten Prozessgases in die zwischen den beiden sich gegenüberliegenden Gaseinlassplatten 24 angeordnete Prozesskammer.

Bezogen auf die Lage der Prozesskammer rückwärtig der Gaseinlassplatte 24 befindet sich ein Volumen, welches von den oben genannten Gaseinspeiseöffnungen 40 mit Prozessgas beziehungsweise Trägergas versorgt wird, was durch die Gasaustrittsöffnungen 39 in die Prozesskammer eintreten kann.

Parallel zur Gaseinlassplatte 24 erstreckt sich eine Rückwand 25 des Gaseinlassorgans. Die Seitenränder der Rückwand 25 sind in die Halteaussparungen 35 eingeschoben. Die Rückwand dichtet das Gaseinlassorgan in Richtung weg von der Gaseinlassplatte 24 ab und begrenzt das Gasvolumen des Gaseinlassorganes. Die Gaseinlassplatte 24 und die Rückwand 25 verlaufen parallel zu einander.

Rückwärtig der Rückwand 25 befindet sich eine weitere Quarzplatte 26, deren Ränder in Halteaussparungen 36 eingeschoben sind.

Rückwärtig der Quarzplatte 26 befindet sich eine Widerstandsheizung 27. Es handelt sich dabei um eine mäanderförmig verlaufende Metallplatte, durch die ein Strom fließen kann, so dass sich das Heizelement 27 aufheizen kann. Die aus Quarz bestehenden Gaseinlassplatte 24, Rückwand 25 und Platte 26 sind im Wesentlichen transparent für die vom Heizelement 27 erzeugte infrarote Strahlung, die das Substrat 6 auf etwa 1.000°C Substrattemperatur aufheizen kann. Es sind Anschlusskontakte vorgesehen, um die beiden Heizelemente 27 zu bestromen.

Rückwärtig des Heizelements 27 befindet sich eine Schirmplatte, die auch als Reflektor wirken kann. Diese Schirmplatte ist an der Halterung des Heizelements 27 befestigt, die auch zur Stromversorgung dient.

In den parallel zu den Vertikalrändern der Wände 48, 48' verlaufenden Halteaussparungen 37, 38 sind die Ränder eines Reflektors 30 und einer Rückwand 31 eingeschoben.

Das Prozesskammergehäuse 19 besitzt eine Decke 49, die entfernbar ist. Wird die Decke 49 bei geöffnetem Deckel 46 entfernt, so können die Platten 24, 25, 26, 37 nach oben aus dem Prozesskammergehäuse 19 herausgezogen werden. Sie können dann gereinigt oder ausgetauscht werden. Ebenso einfach lassen sich die Platten 24, 25, 26, 30, 31 wieder in die ihnen zugeordneten Halteaussparungen 34 bis 38 einschieben.

Die Bodenplatte 50 besitzt Gasaustrittsöffnungen 41, aus denen das durch die Öffnung 39 in die Prozesskammer eingeströmte Gas aus der Prozesskammer austreten kann. Es sind ferner Gasaustrittsöffnungen 42 vorgesehen, die zum Austritt eines Spülgases dienen, welches in den Raum jenseits der beiden Showerheads, in denen sich das Heizelement 27 befindet, eingespeist wird.

Die oben erwähnten Führungselemente 21, 22, 33 besitzen jeweils eine nutförmige Ausnehmung 21', 22', 33', welche mit einem abgerundeten Mündungsbereich Findungsflanken für die Randkante des Substratträgers 1 ausbilden.

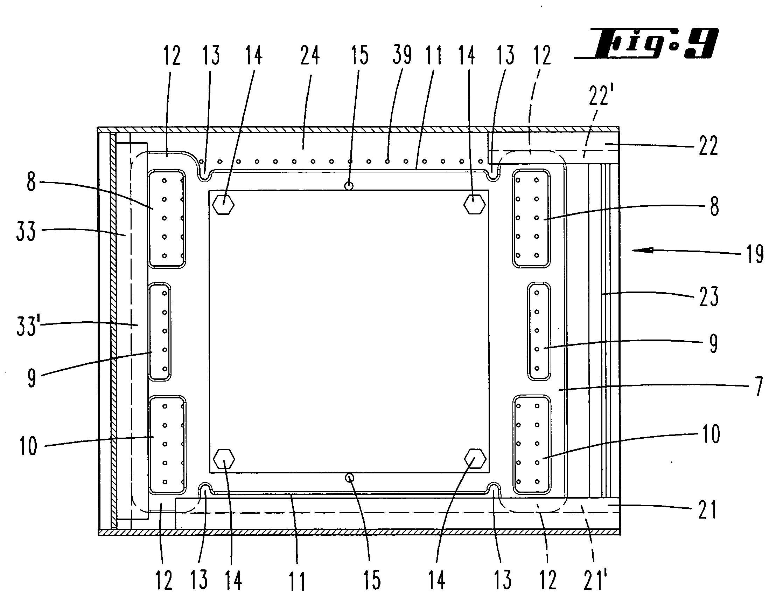

Aus der Figur 9 ist ersichtlich, dass die Randkanten 11 in eingeschobenem Zustand frei sind. Sie besitzen einen Abstand zu den Führungselementen 21 beziehungsweise 22.

Vor der Beladeöffnung 23 des Prozesskammergehäuses 19 befindet sich ein um eine Vertikalachse drehbarer Reflektor 32. Im Betrieb der Prozesskammer nimmt der drehbare Reflektor 32 eine Position ein, dass seine Reflektionsfläche vor der Beladeöffnung 23 steht. Soll die Prozesskammer be- beziehungsweise entladen werden, so wird der drehbare Reflektor 32 verschwenkt, so dass die beiden miteinander fluchtenden Öffnungen 23, 43 frei zum Durchtritt des Substratträgers 1 sind.

Es sind insbesondere zwei parallel zueinander verlaufende Gehäusewände 48, 48' vorgesehen, die jeweils Hohlräume 28 zur Gaseinspeisung durch Gaseinspeiseöffnung 40 in das Gasvolumen des Gaseinlassorgans 24, 25 aufweisen. Die Öffnungen 40 erstrecken sich in gleichmäßiger Beabstandung über die gesamte Tiefe der Gehäusewand 48, 48'. Jede der beiden Gehäusewände 48, 48' kann von zwei Teilwänden ausgebildet sein, wobei jede der beiden Teilwände eine Gaseinspeiseeinrichtung 28 in Form eines Hohlraums ausbildet. Jede Teilwand ist einen von zwei Gaseinlassorganen 24, 25 zugeordnet die Gehäusewände 48, 48' können von mehreren mit einander verbundenen Bauteilen ausgebildet sein, so dass sich innerhalb der Gehäusewand 48, 48' der besagte Hohlraum 28 ausbildet. Der Hohlraum wird mit einer Gaseinspeiseleitung mit Prozessgas versorgt. Die diesbezügliche Öffnung des Hohlraums 28 kann an einer Schmalseite der gehäusewand 48, 48' vorgesehen sein. Es handelt sich bevorzugt um eine untere oder eine obere Schmalseite der Gehäusewand 48, 48', die mit einer Zuleitung verbunden ist, durch die das Prozessgas in den Hohlraum 28 eingespeist werden kann. Die in den Zeichnungen nicht dargestellte Zuleitung verläuft dabei durch die Wandung des Reaktorgehäuses 20 nach außerhalb des Reaktors, wo sich eine Gasversorgungseinrichtung befindet, mit der die Zuleitung verbunden ist.

Der Hohlraum 28 besitzt im Ausführungsbeispiel einen im Wesentlichen rechteckigen Querschnitt es ist aber auch vorgesehen, dass der Hohlraum 28 lediglich von einer oder mehreren Bohrungen ausgebildet ist, die ein geringes Volumen aufweisen.

**Bezugszeichenliste:**

| | | | |
|---|---|---|---|
| 1 | Substratträger | 22 | Führungselement 22' Nut |
| 2 | Breitseitenfläche | 23 | Be-/Entladeöffnung |
| 3 | Breitseitenfläche | 24 | Gaseinlassorgan, -platte |
| 4 | Substrat-Aufnahmezone | 25 | Rückwand |
| 4' | Rand | 26 | Quarzplatte |
| 5 | Substrat-Aufnahmezone | 27 | Heizelement |
| 5' | Rand | 28 | Gaseinspeiseeinrichtung; Hohlraum |
| 6 | Substrat | 29 | Schirmplatte |
| 7 | Handhabungs-/Randabschnitt | 30 | Reflektor |
| 8 | Öffnung | 31 | Rückwand |
| 9 | Öffnung | 32 | drehbarer Reflektor |
| 10 | Öffnung | 33 | Halteelement |
| 11 | Randkante | 33' | Nut, Ausnehmung |
| 12 | Vorsprung/Führungsabschnitt | 34 | Halteaussparung |
| 13 | Einbuchtung | 35 | Halteaussparung |
| 14 | Fixierelement/Schraube | 36 | Halteaussparung |
| 14' | Fixierelement/Mutter | 37 | Halteaussparung |
| 15 | Bohrung | 38 | Halteaussparung |
| 16 | Bohrung | 39 | Gasaustrittsöffnung |
| | | 40 | Gaseinspeiseöffnung |
| | | 41 | Gasaustrittsöffnung |
| 19 | Prozesskammergehäuse | 42 | Gasaustrittsöffnung |
| 20 | Reaktorgehäuse | 43 | Beladeöffnung |
| 21 | Führungselement | 44 | Wand |
| 21' | Nut, Ausnehmung | 44' | Wand |
| 45 | Wand | | |
| 45' | Wand | | |
| 46 | Wand, Deckel | | |
| 47 | Temperierkanal | | |
| 48 | Gehäusewand | | |
| 48' | Gehäusewand | | |
| 49 | Deckenplatte | | |
| 50 | Bodenplatte | | |

## Patentansprüche

1. Vorrichtung zum Abscheiden von insbesondere kohlenstoffhaltigen Strukturen bspw. Schichten in Form von Nanoröhrchen oder Graphene auf einem Substrat (6), welches von einem in einem Prozesskammergehäuse (19) angeordneten sich in einer Ebene erstreckenden Substratträger (1) getragen wird, wobei das Prozesskammergehäuse (19) einen bezogen auf die Ebene klappsymmetrischen Aufbau besitzt und der Substratträger (1) ein sich in der Symmetrieebene erstreckender Flachkörper ist, dessen beiden Breitseiten jeweils ein Substrat tragen können und jede der beiden Breitseitenflächen (2) des Substratträgers (1) eine Gasaustrittsöffnungen (39) aufweisende Gaseinlassplatte (24) eines Gaseinlassorganes (24, 25) gegenüberliegt, wobei durch die Gasaustrittsöffnungen (39) ein Prozessgas in Richtung auf das Substrat (6) einspeisbar ist, wobei das Prozesskammergehäuse (19) zumindestens eine Wand (48, 48') mit Hohlraum (28) aufweist, wobei der Hohlraum (28) mittels Gaseinspeiseöffnungen (40) mit einem rückwärtig der Gaseinlassplatte (24) angeordneten Gasvolumen des Gaseinlassorganes (24, 25) verbunden ist.

2. Vorrichtung nach Anspruch 1, **dadurch gekennzeichnet, dass** die Gaseinspeiseöffnungen (40) zwischen einer Rückwand (25) und der Gaseinlassplatte (24) münden.

3. Vorrichtung nach einem der vorhergehenden Ansprüche, **dadurch gekennzeichnet, dass** das Prozesskammergehäuse (19) gegenüberliegende Wände (48, 48') mit Hohlräumen (28) aufweist wobei jeder Hohlraum (28) mit Gaseinspeiseöffnungen (40) mit dem Gasvolumen des Gaseinlassorganes (24, 25) verbunden ist.

4. Vorrichtung nach einem der vorhergehenden Ansprüche, **dadurch gekennzeichnet, dass** der mindestens eine Hohlraum (28) mit einer Zuleitung mit einem Gasmischsystem verbunden ist, welches das Prozessgas bereitstellt, wobei die Zuleitung insbesondere eine Schmalseite der Wand (48, 48') zugeordnet ist.

5. Vorrichtung nach einem der vorhergehenden Ansprüche, **dadurch gekennzeichnet, dass** das Prozesskammergehäuse (19) zwei sich gegenüberliegende und zum Substratträger (1) senkrechte Wände (48, 48') mit Halteaussparungen (34, 35, 36, 37, 38) aufweist, in denen zwei voneinander wegweisende Randabschnitte eines plattenförmigen Bauteils stecken, welches die Gaseinlassplatte (24) und/oder eine Rückwand (25) des Gaseinlassorgans (24, 25) und/ oder eine Abschirmplatte (26) und/oder ein Reflektor (30) und/oder eine Rückwand (31) des Prozesskammergehäuses (19) ist und welches durch seine Verlagerung in seiner Erstreckungsebene aus dem Prozesskammergehäuse (19) entfernbar ist.

6. Vorrichtung nach einem der vorhergehenden Ansprüche, **dadurch gekennzeichnet, dass** rückwärtig des Gaseinlassorgans (24, 25) eine Heizeinrichtung (27) insbesondere zur Erzeugung infraroter Strahlung angeordnet ist.

7. Vorrichtung nach einem der Ansprüche 2 bis 6, **dadurch gekennzeichnet, dass** die Gasaustrittsplatte (24), die Rückwand (25) und gegebenenfalls eine rückwärtig der Rückwand (25) angeordnete Platte (26) aus einem wärmestrahldurchlässigen Material, insbesondere aus Quarz bestehen.

8. Vorrichtung nach einem der Ansprüche 5 bis 7, **dadurch gekennzeichnet, dass** sämtliche plattenförmigen Bauteile (24, 25, 26, 30, 31) in Parallelebenen angeordnet sind und in Vertikalrichtung aus dem Prozesskammergehäuse (19) entnommen werden können, wobei der sich in einer Parallelebene dazu erstreckende Substratträger (1) durch eine Beladeöffnung (23, 43) aus dem Prozesskammergehäuse (19) entnehmbar ist.

9. Vorrichtung nach einem der vorhergehenden Ansprüche, **dadurch gekennzeichnet, dass** das Prozesskammergehäuse (19) in einem nach außen gasdichten Reaktorgehäuse (20) angeordnet ist, welches einen um eine Schwenkachse öffenbaren Deckel (46) aufweist.

10. Vorrichtung nach einem der vorhergehenden Ansprüche, **dadurch gekennzeichnet, dass** die Wände des Reaktorgehäuses (20) temperierbar sind und hierzu insbesondere Kühlkanäle (47) aufweisen.

11. Vorrichtung nach einem der vorhergehenden Ansprüche, **dadurch gekennzeichnet, dass** eine den Boden des Prozesskammergehäuses (19) bildende Bodenplatte (50) Gasaustrittsöffnungen (41, 42) aufweist.

## Claims

1. A device for depositing in particular structures containing carbon, for example layers in the form of nanotubes or graphene, on a substrate (6) which is carried by a substrate carrier (1) which extends in one plane and which is disposed in a processing-chamber housing (19), wherein the processing-chamber housing (19) has a construction which is symmetrically folded in relation to the plane and the substrate carrier (1) is a planar body which extends in the symmetrical plane and of which both broadsides each can carry one substrate, and each of the two broadside faces (2) of the substrate carrier (1) lies opposite a gas-inlet plate (24), having gas-outlet openings (39), of a gas-inlet element (24, 25), wherein a process gas is infeedable through the gas-outlet openings (39) in the direction of the substrate (6), wherein the processing-chamber housing (19) has at least one wall (48, 48') having a cavity (28), wherein the cavity (28) by means of gas-infeed openings (40) is connected to a gas volume of the gas-inlet element (24, 25) that is disposed to the rear of the gas-inlet plate (24).

2. The device as claimed in claim 1, **characterized in that** the gas-infeed openings (40) open out between a rear wall (25) and the gas-inlet plate (24).

3. The device as claimed in one of the preceding claims, **characterized in that** the processing-chamber housing (19) has mutually opposite walls (48, 48') having cavities (28), wherein each cavity (28) by way of gas-infeed openings (40) is connected to the gas volume of the gas-inlet element (24, 25).

4. The device as claimed in one of the preceding claims, **characterized in that** the at least one cavity (28) by way of a supply line is connected to a gas-mixing system which provides the process gas, wherein the supply line is assigned in particular to a narrow side of the wall (48, 48').

5. A device as claimed in one of the preceding claims, **characterized in that** the processing-chamber housing (19) has two mutually opposite walls (48, 48') which are perpendicular to the substrate carrier (1) and which have retaining clearances (34, 35, 36, 37, 38) in which two peripheral portions, pointing away from one another, of a plate-shaped component are plug-fitted, said plate-shaped component being the gas-inlet plate (24) and/or a rear wall (25) of the gas-inlet element (24, 25), and/or a shielding plate (26), and/or a reflector (30), and/or a rear wall (31) of the processing-chamber housing (19), and said plate-shaped component by being displaced in the plane of extent thereof being removable from the processing-chamber housing (19).

6. The device as claimed in one of the preceding claims, **characterized in that** a heating unit (27) in particular for generating infrared radiation is disposed to the rear of the gas-inlet element (24, 25).

7. The device as claimed in one of claims 2 to 6, **characterized in that** the gas-outlet plate (24), the rear wall (25) and, if applicable, a plate (26) which is disposed to the rear of the rear wall (25) are composed of a material which is permeable to thermal radiation, in particular of quartz.

8. The device as claimed in one of claims 5 to 7, **characterized in that** all plate-shaped components (24, 25, 26, 30, 31) are disposed in parallel planes and can be removed from the processing-chamber housing (19) in the vertical direction, wherein the substrate carrier (1) which extends in a parallel plane thereto is removable from the processing-chamber housing (19) through a loading opening (23, 43).

9. The device as claimed in one of the preceding claims, **characterized in that** the processing-chamber housing (19) is disposed in a reactor housing (20) which is outwardly gas-tight and which includes a cover (46) which is openable about a pivot axis.

10. The device as claimed in one of the preceding claims, **characterized in that** the walls of the reactor housing (20) are controllable for temperature and, to this end, include in particular cooling ducts (47).

11. The device as claimed in one of the preceding claims, **characterized in that** a base plate (50) which forms the base of the processing-chamber housing (19) includes gas-outlet openings (41, 42).

## Revendications

1. Dispositif pour le dépôt de structures notamment contenant du carbone, par exemple des couches sous forme de nanotubes ou de graphène sur un substrat (6) qui est supporté par un support de substrat (1) agencé dans un boîtier de chambre de traitement (19) et s'étendant dans un plan, dans lequel le boîtier de chambre de traitement (19) présente une structure à symétrie par rabattement par rapport au plan et le support de substrat (1) est un corps plat s'étendant dans le plan de symétrie dont les deux grands côtés peuvent chacun porter un substrat et chacune des deux surfaces de grand côté (2) du support de substrat (1) fait face à une plaque d'entrée de gaz (24) d'un organe d'entrée de gaz (24, 25) laquelle présente des ouvertures de sortie de gaz (39), dans lequel un gaz de traitement peut être introduit par les ouvertures de sortie de gaz (39) en direction du substrat (6), dans lequel le boîtier de chambre de traitement (19) comprend au moins une paroi (48, 48') avec une cavité (28), dans lequel la cavité (28) est reliée par des ouvertures d'alimentation en gaz (40) à un volume de gaz de l'organe d'entrée de gaz (24, 25) agencé à l'arrière de la plaque d'entrée de gaz (24).

2. Dispositif selon la revendication 1, **caractérisé en ce que** les ouvertures d'alimentation en gaz (40) débouchent entre une paroi arrière (25) et la plaque d'entrée de gaz (24).

3. Dispositif selon l'une des revendications précédentes, **caractérisé en ce que** le boîtier de chambre de traitement (19) présente des parois opposées (48, 48') avec des cavités (28), dans lequel chaque cavité (28) est reliée avec des ouvertures d'alimentation en gaz (40) au volume de gaz de l'organe d'entrée de gaz (24, 25).

4. Dispositif selon l'une des revendications précédentes, **caractérisé en ce que** l'au moins une cavité (28) est reliée avec une conduite d'alimentation à un système de mélange de gaz qui fournit le gaz de traitement, dans lequel la conduite d'alimentation est associée en particulier à un côté étroit de la paroi (48, 48').

5. Dispositif selon l'une des revendications précédentes, **caractérisé en ce que** le boîtier de chambre de traitement (19) présente deux parois (48, 48') opposées l'une à l'autre et perpendiculaires au support de substrat (1), qui présentent des évidements de maintien (34, 35, 36, 37, 38) dans lesquels sont insérées deux parties de bord, orientées à l'opposé l'une de l'autre, d'un composant en forme de plaque qui est la plaque d'entrée de gaz (24) et/ou une paroi arrière (25) de l'organe d'entrée de gaz (24, 25) et/ou une plaque de blindage (26) et/ou un réflecteur (30) et/ou une paroi arrière (31) du boîtier de chambre de traitement (19) et qui peut être retiré du boîtier de chambre de traitement (19) par son déplacement dans son plan d'extension.

6. Dispositif selon l'une des revendications précédentes, **caractérisé en ce qu'**un dispositif de chauffage (27), en particulier pour générer un rayonnement infrarouge, est agencé à l'arrière de l'organe d'entrée de gaz (24, 25).

7. Dispositif selon l'une des revendications 2 à 6, **caractérisé en ce que** la plaque de sortie de gaz (24), la paroi arrière (25) et le cas échéant une plaque (26) agencée à l'arrière de la paroi arrière (25) sont constituées d'un matériau transparent au rayonnement thermique, en particulier de quartz.

8. Dispositif selon l'une des revendications 5 à 7, **caractérisé en ce que** tous les composants en forme de plaques (24, 25, 26, 30, 31) sont agencés dans des plans parallèles et peuvent être retirés du boîtier de chambre de traitement (19) dans la direction verticale, dans lequel le support de substrat (1) s'étendant dans un plan qui leur est parallèle peut être retiré du boîtier de chambre de traitement (19) à travers une ouverture de chargement (23, 43).

9. Dispositif selon l'une des revendications précédentes, **caractérisé en ce que** le boîtier de chambre de traitement (19) est agencé dans un boîtier de réacteur (20) étanche aux gaz vers l'extérieur, qui présente un couvercle (46) pouvant être ouvert autour d'un axe de pivotement.

10. Dispositif selon l'une des revendications précédentes, **caractérisé en ce que** les parois du boîtier de réacteur (20) sont régulables en température et présentent à cet effet en particulier des canaux de refroidissement (47).

11. Dispositif selon l'une des revendications précédentes, **caractérisé en ce qu'**une plaque de fond (50) formant le fond du boîtier de chambre de traitement (19) présente des ouvertures de sortie de gaz (41, 42).
